# EUROPEAN PATENT APPLICATION

(11) **EP 4 528 788 A1**
(43) Date of publication of application: **26.03.2025**
(21) Application number: 23807593.1
(22) Date of filing: 15.05.2023
(51) Int. Cl.: H01L 21/205, C23C 16/44

(54) **MAINTENANCE METHOD FOR SEMICONDUCTOR MANUFACTURING APPARATUS**

(30) Priority: 19.05.2022 JP 2022082583
(71) Applicant: NuFlare Technology, Inc., Yokohama-shi, Kanagawa 235-8522 (JP)
(72) Inventor: DAIGO, Yoshiaki, Yokohama-shi, Kanagawa 235-8522 (JP); HARAGUCHI, Takashi, Yokohama-shi, Kanagawa 235-8522 (JP); MORIYAMA, Yoshikazu, Yokohama-shi, Kanagawa 235-8522 (JP)
(74) Representative: Hoffmann Eitle
(86) International application number: PCT/JP2023/018041
(87) International publication number: WO 2023/223991

(57) **Abstract**

A maintenance method for a semiconductor manufacturing apparatus according to an embodiment includes: separating a first seal portion and a second seal portion of a chamber having the first seal portion and the second seal portion; introducing air into the chamber from the separated first seal portion; and sucking a gas in the chamber from the separated second seal portion using an intake device.

## Description

### TECHNICAL FIELD

The present invention relates to a maintenance method for a semiconductor manufacturing apparatus.

### BACKGROUND ART

As a method of forming a high-quality semiconductor film, there is an epitaxial growth technique for forming a single crystal film on a substrate by vapor phase growth. In a vapor phase growth apparatus using the epitaxial growth technique, a substrate is placed on a holder in a chamber held at normal pressure or reduced pressure.

Then, a process gas containing a raw material for a film is supplied to the chamber while heating the substrate. Thermal decomposition and chemical reaction of the process gas occur on the surface of the substrate, forming an epitaxial single crystal film on the surface of the substrate.

After the epitaxial single crystal film is grown, by-products remain inside the chamber. During the maintenance of the inside of the chamber, a reaction between the by-products and the air may cause a gas derived from the by-products to be generated and emitted to the outside of the chamber. When the gas derived from by-products is harmful to the human body or corrodes components of surrounding production facilities, it is desirable to suppress the emission of such gas to the outside of the chamber.

### CITATION LIST

### PATENT DOCUMENT

Patent Document 1: JP 2010-212430 A

### SUMMARY OF THE INVENTION

### PROBLEM TO BE SOLVED BY THE INVENTION

A problem to be solved by the invention is to provide a maintenance method for a semiconductor manufacturing apparatus that suppresses the emission of gas derived from by-products remaining in a chamber to the outside of the apparatus.

### MEANS FOR SOLVING PROBLEM

A maintenance method for a semiconductor manufacturing apparatus according to an aspect of the invention includes: separating a first seal portion and a second seal portion of a chamber having the first seal portion and the second seal portion; introducing air into the chamber from the separated first seal portion; and sucking a gas in the chamber from the separated second seal portion using an intake device.

### EFFECT OF THE INVENTION

According to the invention, it is possible to realize a maintenance method for a semiconductor manufacturing apparatus that suppresses the emission of gas derived from by-products remaining in a chamber to the outside of the apparatus.

### BRIEF DESCRIPTION OF DRAWINGS

Fig. 1 is a schematic cross-sectional view of a semiconductor manufacturing apparatus to be maintained in a maintenance method for a semiconductor manufacturing apparatus according to a first embodiment;
Fig. 2 is a bottom view of an upper plate of the first embodiment;
Fig. 3 is a top view of a lower plate of the first embodiment;
Fig. 4 is a top view of a modification example of the lower plate of the first embodiment;
Fig. 5 is an explanatory diagram of a vapor phase growth method of the first embodiment;
Fig. 6 is an explanatory diagram of by-products adhering to the inside of a chamber;
Fig. 7 is an explanatory diagram of the maintenance method for a semiconductor manufacturing apparatus according to the first embodiment;
Fig. 8 is an explanatory diagram of the maintenance method for a semiconductor manufacturing apparatus according to the first embodiment;
Fig. 9 is an explanatory diagram of the maintenance method for a semiconductor manufacturing apparatus according to the first embodiment;
Fig. 10 is an explanatory diagram of the maintenance method for a semiconductor manufacturing apparatus according to the first embodiment;
Fig. 11 is an explanatory diagram of a modification example of the maintenance method for a semiconductor manufacturing apparatus according to the first embodiment;
Fig. 12 is an explanatory diagram of a maintenance method for a semiconductor manufacturing apparatus according to a second embodiment;
Fig. 13 is an explanatory diagram of the maintenance method for a semiconductor manufacturing apparatus according to the second embodiment;
Fig. 14 is an explanatory diagram of the maintenance method for a semiconductor manufacturing apparatus according to the second embodiment;
Fig. 15 is an explanatory diagram of a maintenance method for a semiconductor manufacturing apparatus according to a

### third embodiment; and

Fig. 16 is an explanatory diagram of a maintenance method for a semiconductor manufacturing apparatus according to a fourth embodiment.

### MODE(S) FOR CARRYING OUT THE INVENTION

Hereinafter, embodiments of the invention will be described with reference to the diagrams.

In this specification, the same or similar members may be denoted by the same reference numerals.

In this specification, the direction of gravity in a state in which a vapor phase growth apparatus is installed so that a film can be formed is defined as "down", and the opposite direction is defined as "up". Therefore, "lower" means a position in the direction of gravity with respect to the reference, and "downward" means the direction of gravity with respect to the reference. Then, "upper" means a position in a direction opposite to the direction of gravity with respect to the reference, and "upward" means a direction opposite to the direction of gravity with respect to the reference. In addition, the "vertical direction" is the direction of gravity.

In addition, in this specification, "process gas" is a general term for gases used for forming a film, and is a concept including, for example, a source gas, an assist gas, a dopant gas, a carrier gas, and a mixed gas thereof.

### (First Embodiment)

A maintenance method for a semiconductor manufacturing apparatus according to a first embodiment includes: separating a first seal portion and a second seal portion of a chamber having the first seal portion and the second seal portion; introducing air into the chamber from the separated first seal portion; and sucking a gas in the chamber from the separated second seal portion using an intake device.

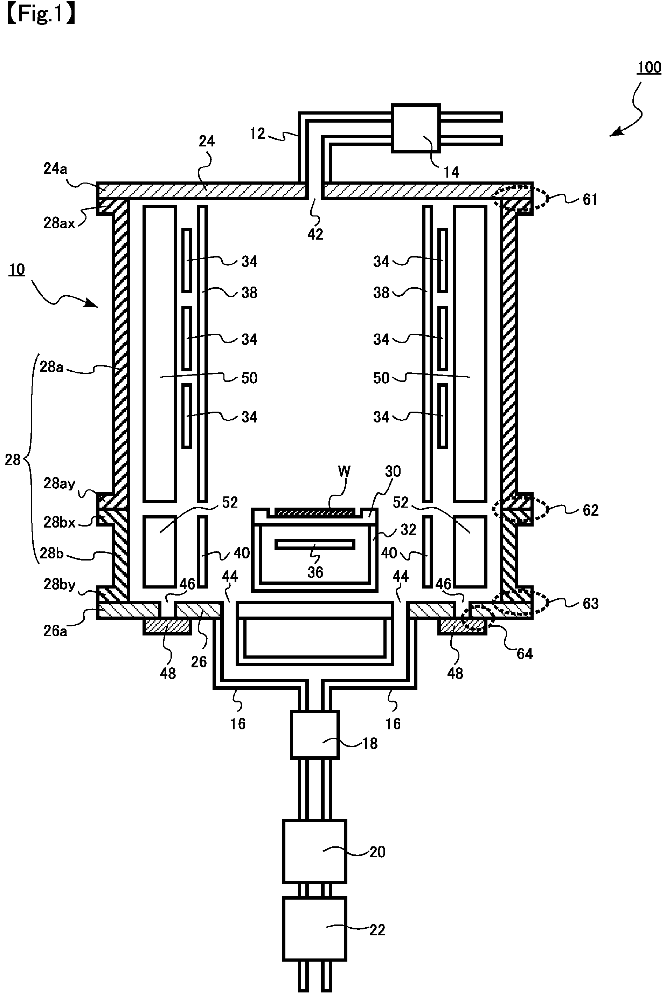

Fig. 1 is a schematic cross-sectional view of a semiconductor manufacturing apparatus to be maintained in the maintenance method for a semiconductor manufacturing apparatus according to the first embodiment. The semiconductor manufacturing apparatus according to the first embodiment is a vapor phase growth apparatus 100. The vapor phase growth apparatus 100 according to the first embodiment is, for example, a single wafer type epitaxial growth apparatus for epitaxially growing a single crystal silicon carbide film on a single crystal silicon carbide substrate.

The vapor phase growth apparatus 100 according to the first embodiment includes a chamber 10, a gas supply pipe 12, a supply valve 14, a gas exhaust pipe 16, an exhaust valve 18, a first vacuum pump 20, and a first exhaust gas treatment equipment 22. The chamber 10 includes an upper plate 24, a lower plate 26, a sidewall 28, a susceptor 30, a rotating body 32, an upper heater 34, a lower heater 36, a hood 38, a liner 40, a gas supply port 42, a gas exhaust port 44, a service port 46, a blank flange 48, an upper heat insulator 50, and a lower heat insulator 52. The sidewall 28 includes an upper wall 28a and a lower wall 28b. The chamber 10 includes an upper seal portion 61, an intermediate seal portion 62, a lower seal portion 63, and a service port seal portion 64.

The chamber 10 is formed of, for example, stainless steel. In the chamber 10, for example, a silicon carbide film is formed on a wafer W. The wafer W is an example of a substrate. The wafer W is, for example, a semiconductor wafer. The wafer W is, for example, a single crystal silicon carbide wafer.

The chamber 10 includes the upper plate 24, the lower plate 26, and the sidewall 28.

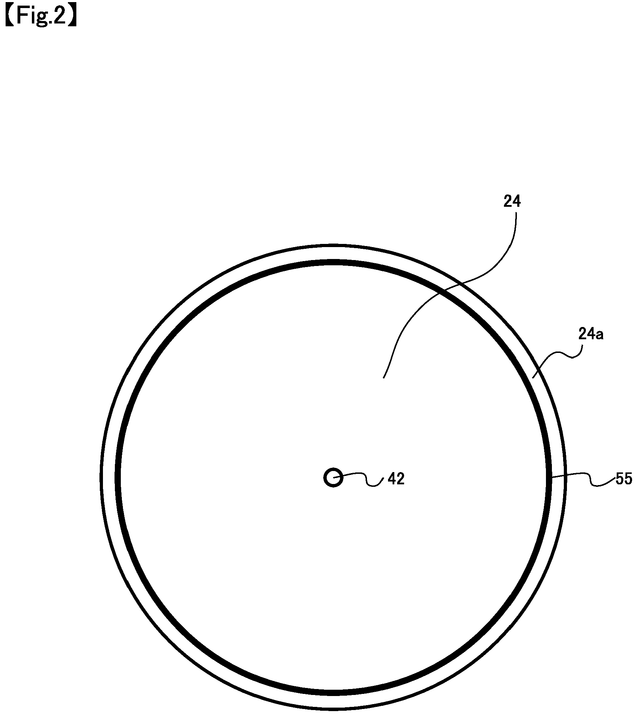

Fig. 2 is a bottom view of the upper plate of the first embodiment. The upper plate 24 has, for example, a disk shape. The upper plate 24 has, for example, a flange 24a around its periphery.

On the outer periphery of the upper plate 24, for example, an O-ring 55 is provided. Instead of the O-ring 55, a gasket can be provided.

In the upper plate 24, the gas supply port 42 for supplying a gas into the chamber 10 is provided. Figs. 1 and 2 illustrate a case where one gas supply port 42 is provided, but a plurality of gas supply ports 42 may be provided.

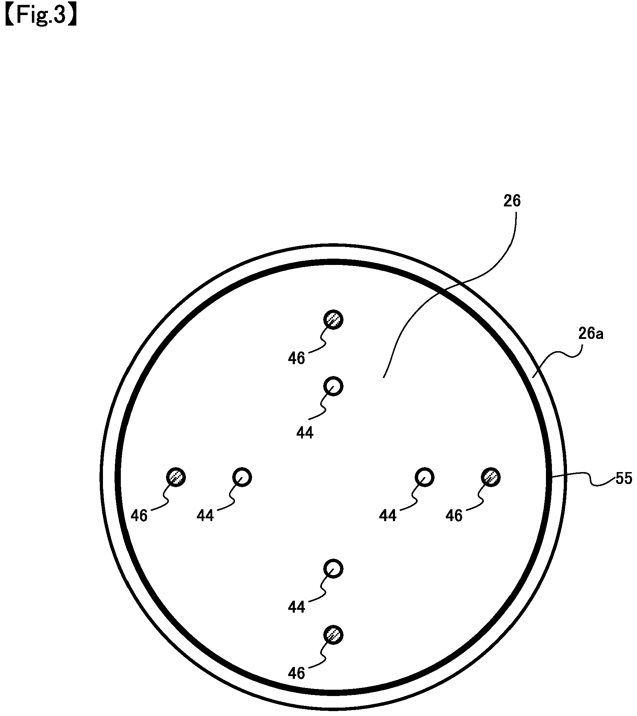

Fig. 3 is a top view of the lower plate of the first embodiment. The lower plate 26 has, for example, a disk shape. The lower plate 26 has, for example, a flange 26a around its periphery.

On the outer periphery of the lower plate 26, for example, the O-ring 55 is provided. Instead of the O-ring 55, a gasket can be provided.

In the lower plate 26, the gas exhaust port 44 for exhausting a gas from the chamber 10 is provided. In addition, in the lower plate 26, the service port 46 for the installation of additional measuring equipment and the like is provided. The service port 46 is a hole provided in the lower plate 26.

The service port 46 is closed by the blank flange 48. Between the lower plate 26 and the blank flange 48, for example, an O-ring or a gasket (not shown) is provided.

As shown in Fig. 3, in the lower plate 26, for example, four gas exhaust ports 44 are provided concentrically. In addition, in the lower plate 26, for example, four service ports 46 are provided concentrically.

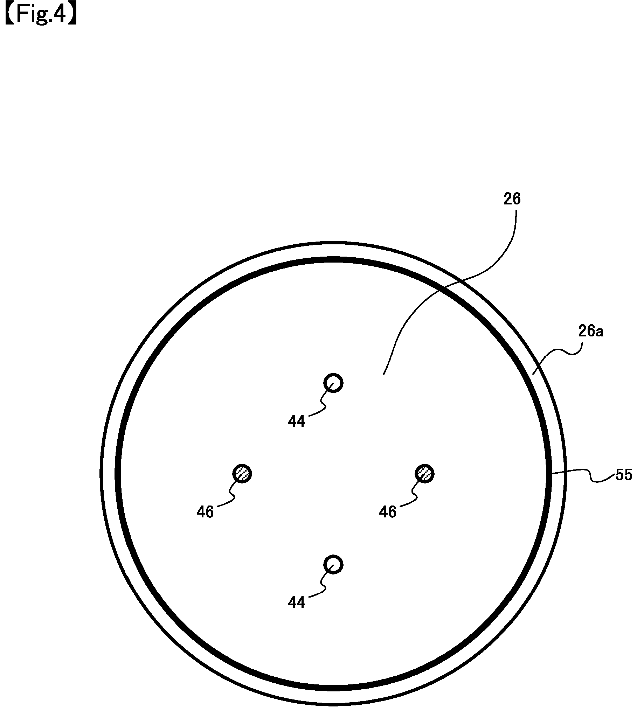

Fig. 4 is a top view of a modification example of the lower plate of the first embodiment. As shown in Fig. 4, in the lower plate 26, for example, two gas exhaust ports 44 are provided. In addition, in the lower plate 26, for example, two service ports 46 are provided. The number and arrangement of gas exhaust ports 44 and service ports 46 provided in the lower plate 26 are not limited to the form shown in Fig. 3 or 4.

The sidewall 28 is provided between the upper plate 24 and the lower plate 26. The sidewall 28 has, for example, a cylindrical shape.

The sidewall 28 includes the upper wall 28a and the lower wall 28b. The lower wall 28b is provided between the upper wall 28a and the lower plate 26.

The upper wall 28a has a flange 28ax and a flange 28ay. The flange 28ax of the upper wall 28a faces the flange 24a of the upper plate 24. Between the flange 28ax and the flange 24a, for example, the O-ring 55 or a gasket is provided.

The lower wall 28b has a flange 28bx and a flange 28by. The flange 28bx of the lower wall 28b faces the flange 28ay of the upper wall 28a. Between the flange 28bx and the flange 28ay, for example, an O-ring or a gasket (not shown) is provided.

The flange 28by of the lower wall 28b faces the flange 26a of the lower plate 26. Between the flange 28by and the flange 26a, for example, the O-ring 55 or a gasket is provided.

The chamber 10 includes the upper seal portion 61, the intermediate seal portion 62, the lower seal portion 63, and the service port seal portion 64. The airtightness of the chamber 10 is maintained by the upper seal portion 61, the intermediate seal portion 62, the lower seal portion 63, and the service port seal portion 64. Due to the upper seal portion 61, the intermediate seal portion 62, the lower seal portion 63, and the service port seal portion 64, the inside of the chamber 10 can be maintained in a vacuum state.

The upper seal portion 61 is a portion where the flange 24a of the upper plate 24 and the flange 28ax of the upper wall 28a face each other. The intermediate seal portion 62 is a portion where the flange 28ay of the upper wall 28a and the flange 28bx of the lower wall 28b face each other. The lower seal portion 63 is a portion where the flange 28by of the lower wall 28b and the flange 26a of the lower plate 26 face each other. The service port seal portion 64 is a portion between the lower plate 26 and the blank flange 48.

The upper seal portion 61 seals between the upper plate 24 and the upper wall 28a. The upper seal portion 61 is separable in the vertical direction. In other words, the flange 24a of the upper plate 24 and the flange 28ax of the upper wall 28a are separable in the vertical direction.

For example, the upper plate 24 is moved upward with respect to the upper wall 28a by a lifting mechanism (not shown). This allows the upper seal portion 61 to be separated in the vertical direction.

The intermediate seal portion 62 seals between the upper wall 28a and the lower wall 28b. The intermediate seal portion 62 is separable in the vertical direction. In other words, the flange 28ay of the upper wall 28a and the flange 28bx of the lower wall 28b are separable in the vertical direction.

For example, the upper wall 28a is moved upward with respect to the lower wall 28b by a lifting mechanism (not shown). This allows the intermediate seal portion 62 to be separated in the vertical direction.

The lower seal portion 63 seals between the lower wall 28b and the lower plate 26. The lower seal portion 63 is separable in the vertical direction. In other words, the flange 28by of the lower wall 28b and the flange 26a of the lower plate 26 are separable in the vertical direction.

For example, the lower wall 28b is moved upward with respect to the lower plate 26 by a lifting mechanism (not shown). This allows the lower seal portion 63 to be separated in the vertical direction.

The service port seal portion 64 seals between the lower plate 26 and the blank flange 48. The service port seal portion 64 is separable in the vertical direction. In other words, the lower plate 26 and the blank flange 48 are separable in the vertical direction. For example, by removing the screws that attach the blank flange 48 to the lower plate 26, the service port seal portion 64 can be separated in the vertical direction.

The gas supply pipe 12 is connected to the gas supply port 42. A process gas is supplied from the gas supply pipe 12 into the chamber 10 through the gas supply port 42. The supply valve 14 for controlling the supply of the process gas is provided in the gas supply pipe 12. In addition, a plurality of supply valves 14 may be provided for each gas type. In addition, the supply valve 14 may have any structure that can control the supply of gas to the chamber 10. That is, the supply valve 14 also includes a three-way valve or the like that enable the supply of gas to the chamber 10 and switching to a vent line (exhaust line) (not shown) with one valve unit.

The gas exhaust port 44 is connected to the gas exhaust pipe 16. For example, an unreacted process gas is exhausted as an exhaust gas from the gas exhaust port 44 through the gas exhaust pipe 16. The exhaust valve 18 for controlling the exhaust of gas is provided in the gas exhaust pipe 16. A stop valve for opening and closing a flow path from the chamber 10 to the first vacuum pump 20, which will be described later, is provided in the exhaust valve 18. In addition, in addition to the stop valve, the exhaust valve 18 may include a variable conductance valve (not shown) for controlling the amount of gas exhausted from the chamber 10 to the first vacuum pump 20 to be described later.

The first vacuum pump 20 for reducing the pressure in the chamber 10 is provided in the gas exhaust pipe 16. In addition, the first exhaust gas treatment equipment 22 for removing toxic substances in the exhaust gas is connected to the gas exhaust pipe 16.

The susceptor 30 is provided in the chamber 10. The wafer W can be placed on the susceptor 30.

The susceptor 30 is placed on the upper part of a rotating body 32. The rotating body 32 is fixed to a rotating shaft (not shown).

The rotating shaft can be rotated by a rotation driving mechanism (not shown). By rotating the rotating shaft, the susceptor 30 can be rotated. By rotating the susceptor 30, the wafer W placed on the susceptor 30 can be rotated.

The lower heater 36 is provided below the susceptor 30. The lower heater 36 is provided within the rotating body 32. The lower heater 36 heats the wafer W held on the susceptor 30 from below.

The upper heater 34 is provided between the hood 38 and the sidewall 28. The upper heater 34 is located above the susceptor 30. The upper heater 34 heats the wafer W held on the susceptor 30 from above.

The hood 38 has, for example, a cylindrical shape. The hood 38 has a function of preventing the process gas from coming in contact with the upper heater 34, for example. The hood 38 has a function of rectifying the process gas, for example.

The liner 40 is provided between the rotating body 32 and the lower heat insulator 52. The liner 40 has, for example, a cylindrical shape. The liner 40 has a function of rectifying the process gas, for example.

The upper heat insulator 50 is provided between the upper heater 34 and the sidewall 28. The lower heat insulator 52 is provided between the liner 40 and the sidewall 28.

Next, an example of a vapor phase growth method using the vapor phase growth apparatus 100 according to the first embodiment will be described. Hereinafter, a case where a single crystal silicon carbide film doped with nitrogen as an n-type impurity is formed on the surface of the single crystal silicon carbide wafer W will be described as an example.

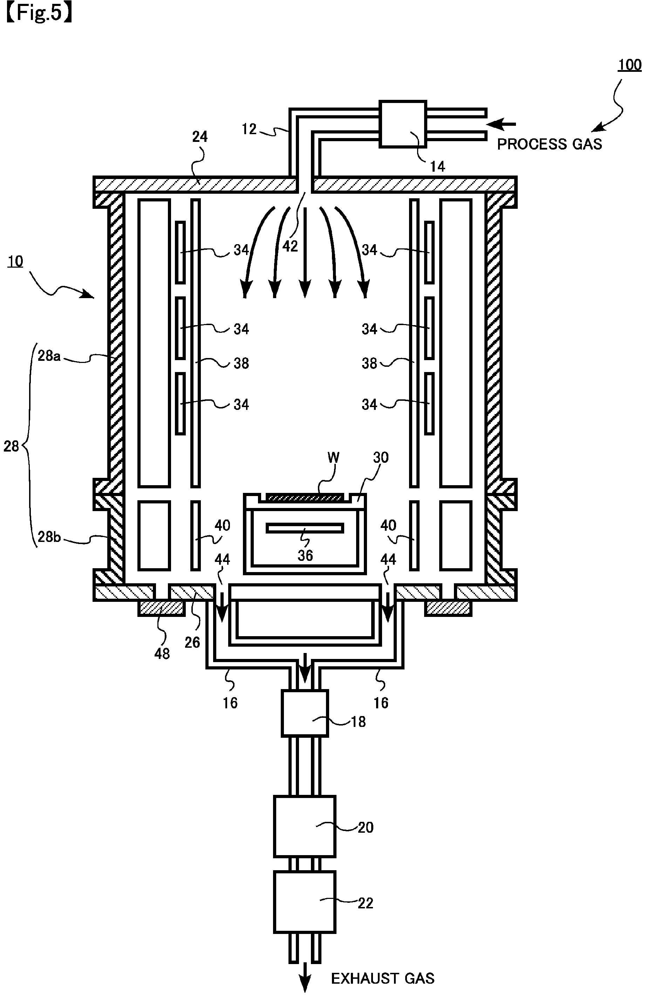

Fig. 5 is an explanatory diagram of the vapor phase growth method of the first embodiment.

First, the wafer W is placed on the susceptor 30. The wafer W is a single crystal silicon carbide wafer.

Then, the wafer W is rotated by a rotation driving mechanism (not shown). Then, the wafer W is heated by the upper heater 34 and the lower heater 36.

Then, as shown in Fig. 5, the supply valve 14 is opened to supply the process gas from the gas supply pipe 12 into the chamber 10.

The process gas is, for example, a mixed gas containing a silicon source gas, a carbon source gas, an n-type impurity dopant gas, an assist gas, and a carrier gas. The silicon source gas is, for example, a silane gas (SiH₄). The carbon source gas is, for example, a propane gas (C₃H₈). The n-type impurity dopant gas is, for example, a nitrogen gas (N₂). The assist gas is, for example, a hydrogen chloride gas (HCl). The carrier gas is, for example, an argon gas (Ar) or a hydrogen gas (H₂).

For example, processing on the wafer W is performed in an atmosphere containing chlorine. For example, processing on the wafer W is performed in an atmosphere containing hydrogen chloride gas (HCl) as an assist gas.

A single crystal silicon carbide film doped with nitrogen as an n-type impurity is formed on the surface of the wafer W by reaction of the process gas.

As shown in Fig. 5, the exhaust valve 18 is opened to exhaust the exhaust gas, such as an unreacted process gas, from the gas exhaust pipe 16 during the formation of the silicon carbide film. The exhaust gas is exhausted after being detoxified by the first vacuum pump 20 and the first exhaust gas treatment equipment 22.

After the single crystal silicon carbide film is formed, the supply valve 14 is closed to stop the supply of the process gas into the chamber 10. In addition, heating by the upper heater 34 and the lower heater 36 is stopped to lower the temperature of the wafer W. Thereafter, the wafer W is unloaded from the chamber 10. In addition, when a plurality of supply valves 14 are provided for each gas type, only the supply valve 14 corresponding to a specific gas may be closed when the wafer W is unloaded from the chamber 10. For example, only the supply valves 14 for silane gas (SiH₄), propane gas (C₃H₈), nitrogen gas (N₂), hydrogen chloride gas (HCl), and hydrogen gas (H₂) can be closed, while the supply valve 14 for argon gas (AR) can be left open. In this manner, the inside of the chamber 10 can be replaced with argon gas (Ar), thereby reducing the risk of toxic gases flowing to the destination of the wafer W unloaded from the chamber 10, such as a transfer chamber or a load-lock chamber.

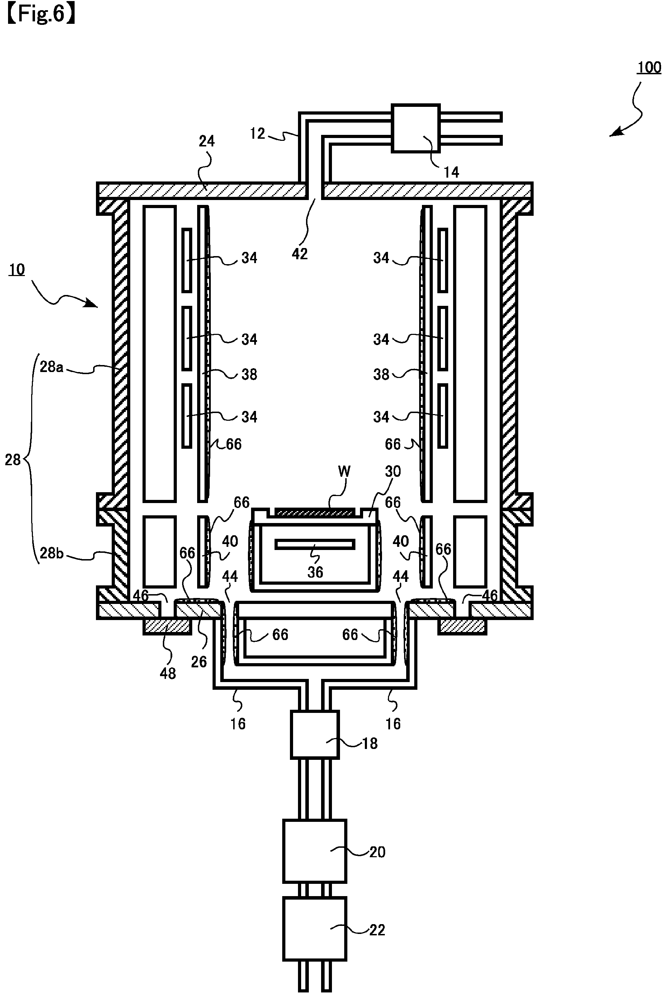

Fig. 6 is an explanatory diagram of by-products adhering to the inside of the chamber.

As shown in Fig. 6, after the single crystal silicon carbide film is formed, primary by-products 66 produced by the reaction of the process gas adhere to the inside of the chamber 10. The by-products 66 adhere to, for example, the surface of the rotating body 32, the surface of the hood 38, the surface of the liner 40, the surface of the lower plate 26, and the surface of the gas exhaust port 44.

The by-products 66 contain, for example, chlorine (Cl). Chlorine contained in the by-products 66 is derived from the hydrogen chloride gas (HCl) that is an assist gas, for example.

Next, a maintenance method for a semiconductor manufacturing apparatus according to the first embodiment will be described.

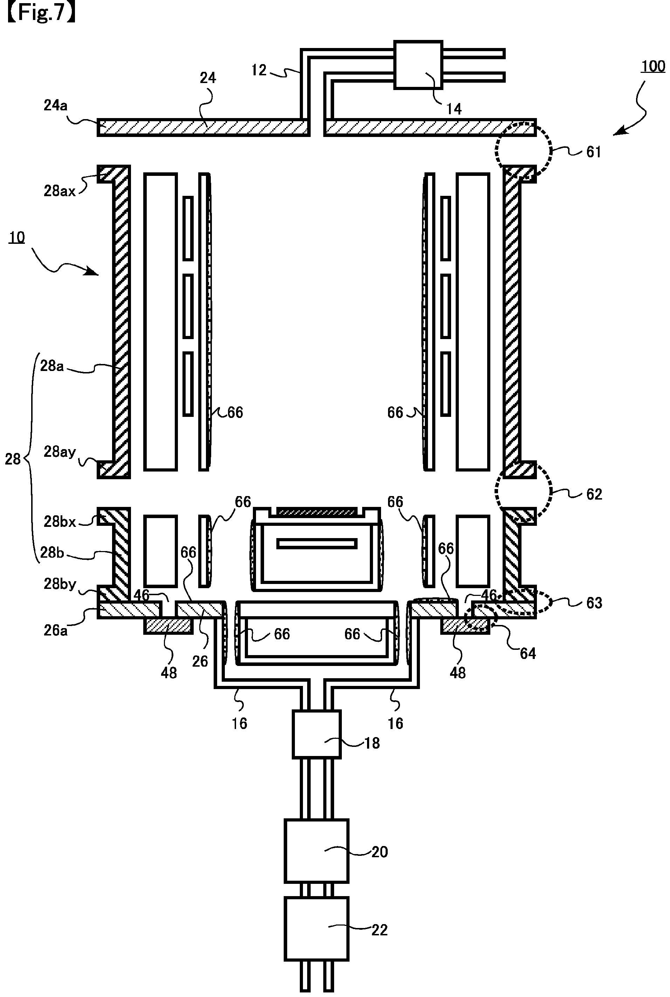

Figs. 7, 8, 9, and 10 are explanatory diagrams of the maintenance method for a semiconductor manufacturing apparatus according to the first embodiment.

For example, after a single crystal silicon carbide film is formed and the wafer W is unloaded from the chamber 10, the upper seal portion 61 and the intermediate seal portion 62 are separated (Fig. 7). The upper seal portion 61 is an example of the first seal portion. The intermediate seal portion 62 is an example of the second seal portion.

For example, the upper plate 24 is moved upward with respect to the upper wall 28a by a lifting mechanism (not shown). As a result, the upper seal portion 61 is separated in the vertical direction.

In addition, for example, the upper wall 28a is moved upward with respect to the lower wall 28b by a lifting mechanism (not shown). As a result, the intermediate seal portion 62 is separated in the vertical direction.

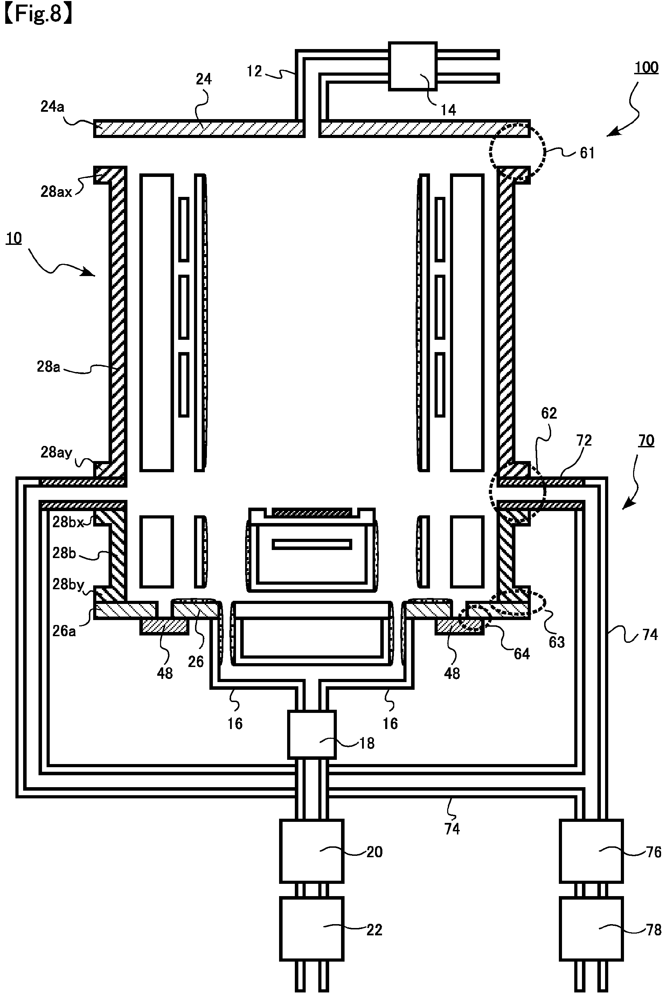

Then, an intake device 70 is attached to the separated intermediate seal portion 62 (Fig. 8).

The intake device 70 includes an annular jig 72, a gas intake pipe 74, a second exhaust gas treatment equipment 76, and a second vacuum pump 78. The annular jig 72 is interposed between the upper wall 28a and the lower wall 28b. The second exhaust gas treatment equipment 76 is simple and easy to use if this is of an adsorption type, but is not limited thereto. In addition, the second vacuum pump 78 may be provided in the intake device 70, but may also be a vacuum line provided in a factory or the like.

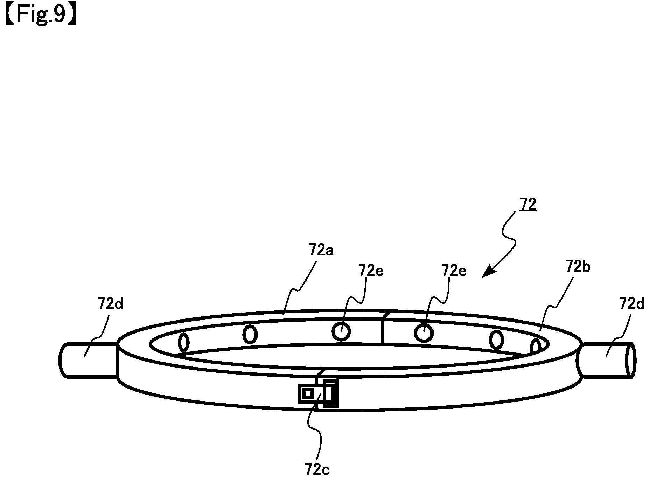

Fig. 9 is a perspective view of an annular jig of an intake device of the first embodiment. The annular jig 72 includes a first portion 72a, a second portion 72b, a locking mechanism 72c, a connection pipe 72d, and an intake port 72e.

The first portion 72a and the second portion 72b are, for example, semicircular. The first portion 72a and the second portion 72b are coupled together to form a ring shape. For example, the first portion 72a and the second portion 72b are coupled together using the locking mechanism 72c.

The first portion 72a and the second portion 72b are hollow. The intake port 72e is provided inside the first portion 72a and the second portion 72b. The gas intake pipe 74 is connected to the connection pipe 72d.

The second exhaust gas treatment equipment 76 for removing toxic substances in the gas taken in through the gas intake pipe 74 is connected to the gas intake pipe 74. In addition, the second vacuum pump 78 for reducing the pressure in the gas intake pipe 74 is provided in the gas intake pipe 74. In addition, the second vacuum pump 78 may be provided in the intake device 70, but may also be a vacuum line provided in a factory or the like.

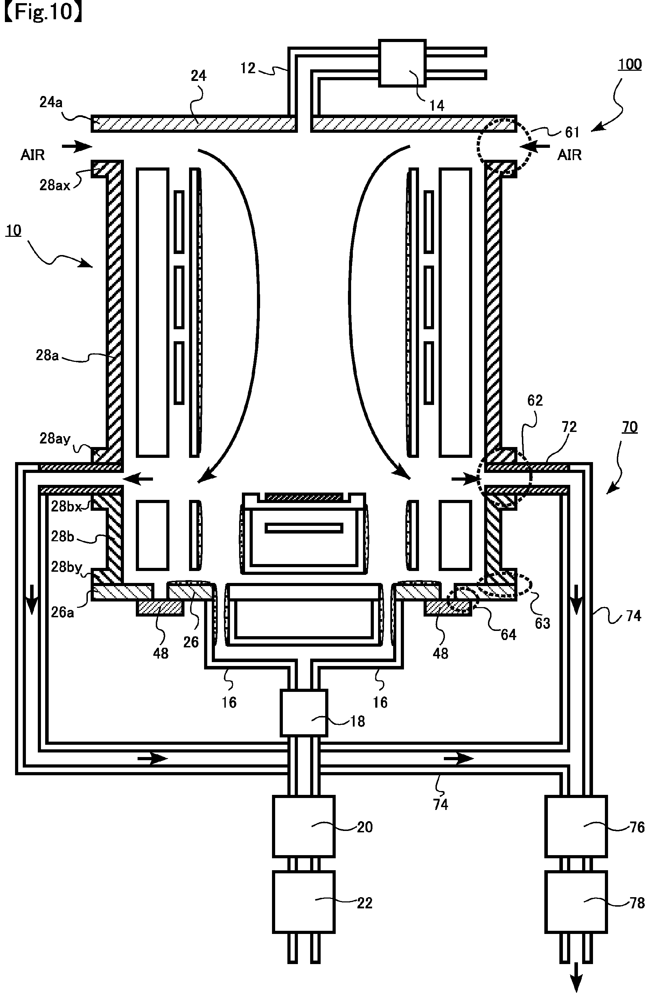

Then, the second vacuum pump 78 is operated to bring the gas intake pipe 74 to a pressure lower than atmospheric pressure. Air flows into the chamber 10 from the separated upper seal portion 61. The air that has flowed into the chamber 10 is sucked through the intake port 72e of the annular jig 72. The air sucked through the intake port 72e passes through the hollow portions of the first portion 72a and the second portion 72b and flows from the connection pipe 72d to the gas intake pipe 74 (Fig. 10).

The by-products 66 adhering to the surface of the rotating body 32, the surface of the hood 38, the surface of the liner 40, the surface of the lower plate 26, and the surface of the gas exhaust port 44 react with the air to become secondary by-products. The secondary by-products are, for example, by-product gases. The generated by-product gases flow into the gas intake pipe 74 together with the air.

After the gas in the chamber 10 has been sucked for a predetermined time, the intake device 70 is removed from the intermediate seal portion 62. Then, the chamber 10 is completely opened to perform maintenance work inside the chamber 10.

For example, the upper plate 24 may be completely separated from the upper wall 28a to perform maintenance work inside the chamber 10. In addition, for example, the upper wall 28a and the lower wall 28b may be completely separated to perform maintenance work inside the chamber 10. Depending on the nature of the maintenance work, a portion to be completely separated is selected.

Next, the function and effect of the maintenance method for a semiconductor manufacturing apparatus according to the first embodiment will be described.

After the single crystal silicon carbide film is formed, the primary by-products 66 produced by the reaction of the process gases adhere to the inside of the chamber 10. The by-products 66 contain, for example, chlorine (Cl) derived from the hydrochloric acid gas (HCl) which is an assist gas.

During the maintenance of the inside of the chamber 10 of the vapor phase growth apparatus 100, the by-products 66 react with the air to form secondary by-products derived from the by-products 66. The secondary by-products may be emitted, for example, as by-product gases. The by-product gases contain, for example, chlorine. The by-product gases containing chlorine are harmful to the human body, for example. In addition, the by-product gases containing chlorine corrode, for example, components of production facilities around the vapor phase growth apparatus 100. At this time, if all of the by-product gases containing chlorine inside the chamber 10 are exhausted through the gas exhaust pipe 16, there is a risk that the reaction by-products will adhere to the exhaust valve 18. When the exhaust valve 18 is a stop valve, the adhesion of reaction by-products is undesirable because the adhesion of reaction by-products degrades the vacuum sealing performance. In addition, when a variable conductance valve is provided, the adhesion of reaction by-products is undesirable because the adhesion of reaction by-products worsens the controllability of the exhaust flow rate.

In the maintenance method for a semiconductor manufacturing apparatus according to the first embodiment, before the chamber 10 is completely opened, one of the seal portions of the chamber 10 is separated to introduce the air from the separated seal portion. In addition, another one of the seal portions of the chamber 10 is separated, and the intake device 70 is attached. Then, by-product gases generated by the reaction between the air and the by-products 66 are sucked using the intake device 70.

Therefore, when the chamber 10 is completely opened, the emission of by-product gases to the outside of the apparatus is suppressed. As a result, it is possible to prevent the by-product gases from causing harm to the human body. In addition, it is possible to suppress the corrosion of the components of the production facilities around the vapor phase growth apparatus 100 by the by-product gases.

As the intake device 70, it is preferable to use the intake device 70 having the annular jig 72 that can be separated into the first portion 72a and the second portion 72b as shown in Fig. 9. By using the intake device 70 described above, it is possible to attach and detach the intake device 70 without interfering with structures inside the chamber 10. Therefore, the efficiency of maintenance work is improved.

### (Modification Examples)

A modification example of the maintenance method for a semiconductor manufacturing apparatus according to the first embodiment is different from the maintenance method for a semiconductor manufacturing apparatus according to the first embodiment in that the second seal portion seals between the lower wall and the lower plate.

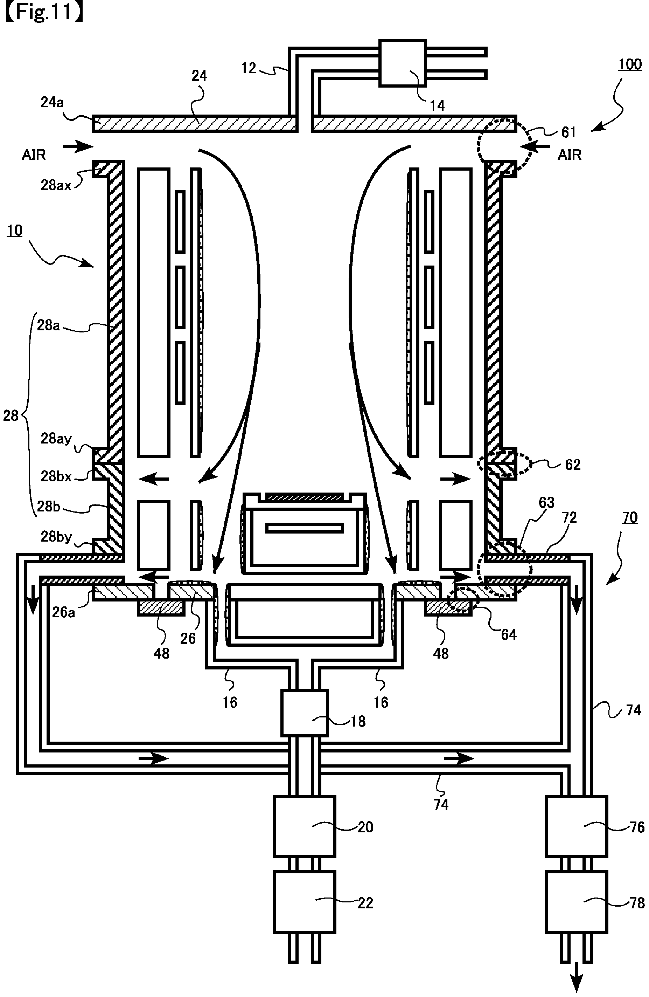

Fig. 11 is an explanatory diagram of a modification example of the maintenance method for a semiconductor manufacturing apparatus according to the first embodiment.

For example, after a single crystal silicon carbide film is formed and the wafer W is unloaded from the chamber 10, the upper seal portion 61 and the lower seal portion 63 are separated. The upper seal portion 61 is an example of the first seal portion. The lower seal portion 63 is an example of the second seal portion.

For example, the upper plate 24 is moved upward with respect to the upper wall 28a by a lifting mechanism (not shown). As a result, the upper seal portion 61 is separated in the vertical direction.

In addition, for example, the lower wall 28b is moved upward with respect to the lower plate 26 by a lifting mechanism (not shown). As a result, the lower seal portion 63 is separated in the vertical direction.

Then, the intake device 70 is attached to the separated lower seal portion 63.

The intake device 70 includes an annular jig 72, a gas intake pipe 74, a second exhaust gas treatment equipment 76, and a second vacuum pump 78. The annular jig 72 is interposed between the lower wall 28b and the lower plate 26.

Then, the second vacuum pump 78 is operated to bring the gas intake pipe 74 to a pressure lower than atmospheric pressure. Air flows into the chamber 10 from the separated upper seal portion 61. The air that has flowed into the chamber 10 is sucked through the intake port 72e of the annular jig 72. The air sucked through the intake port 72e passes through the hollow portions of the first portion 72a and the second portion 72b and flows from the connection pipe 72d to the gas intake pipe 74.

The by-products 66 adhering to the surface of the rotating body 32, the surface of the hood 38, the surface of the liner 40, the surface of the lower plate 26, and the surface of the gas exhaust port 44 react with the air to become secondary by-products. The secondary by-products are, for example, by-product gases. The generated by-product gases flow into the gas intake pipe 74 together with the air.

After the gas in the chamber 10 has been sucked for a predetermined time, the intake device 70 is removed from the lower seal portion 63. Then, the chamber 10 is completely opened to perform maintenance work inside the chamber 10.

As described above, according to the maintenance method for a semiconductor manufacturing apparatus according to the first embodiment and its modification example, it is possible to suppress the emission of gas derived from by-products remaining in the chamber to the outside of the apparatus.

### (Second Embodiment)

A maintenance method for a semiconductor manufacturing apparatus according to a second embodiment is different from the maintenance method for a semiconductor manufacturing apparatus according to the first embodiment in that the second seal portion seals between the lower plate and the blank flange. Hereinafter, the description of a part of the content overlapping the first embodiment may be omitted.

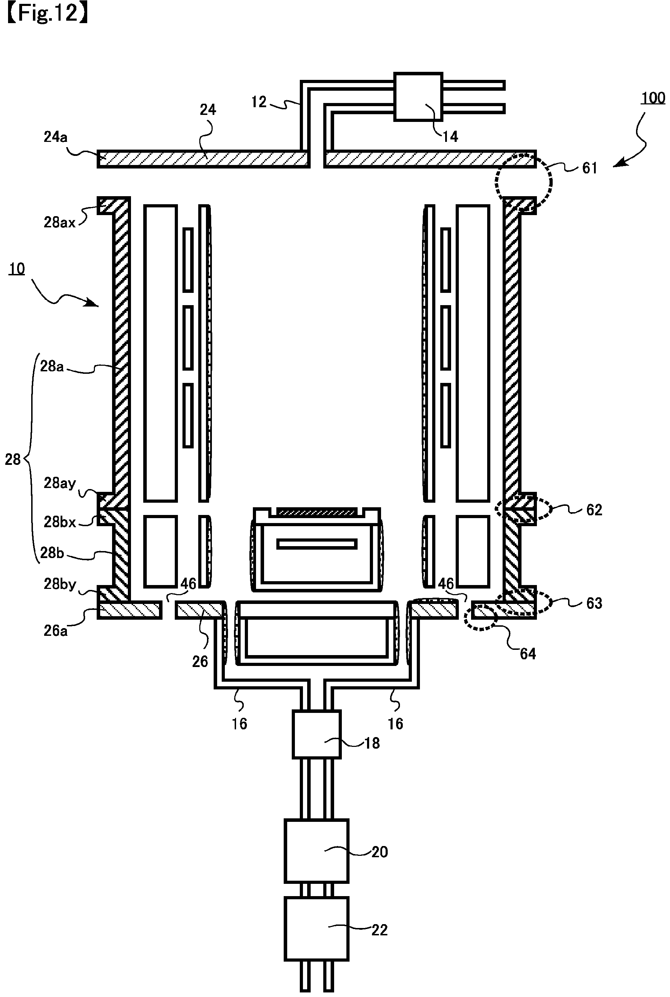

Figs. 12, 13, and 14 are explanatory diagrams of the maintenance method for a semiconductor manufacturing apparatus according to the second embodiment.

For example, after a single crystal silicon carbide film is formed and the wafer W is unloaded from the chamber 10, the upper seal portion 61 and the service port seal portion 64 are separated (Fig. 12). The upper seal portion 61 is an example of the first seal portion. The service port seal portion 64 is an example of the second seal portion.

For example, the upper plate 24 is moved upward with respect to the upper wall 28a by a lifting mechanism (not shown). As a result, the upper seal portion 61 is separated in the vertical direction.

In addition, for example, by removing the screws that attach the blank flange 48 to the lower plate 26, the service port seal portion 64 is separated in the vertical direction.

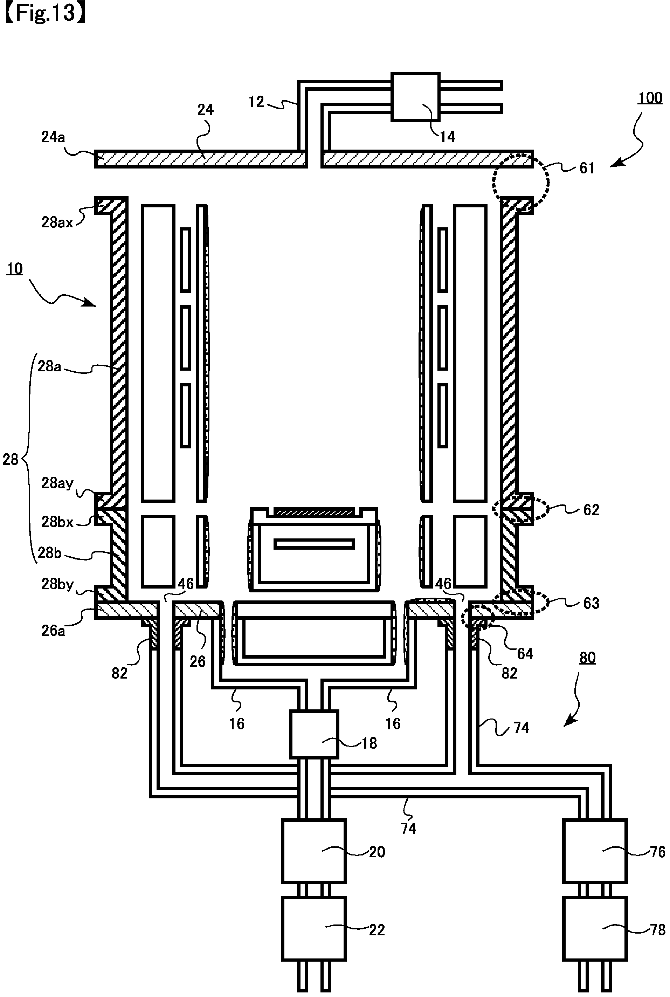

Then, an intake device 80 is attached to the separated service port seal portion 64 (Fig. 13). The intake device 80 is attached to the service port 46.

The intake device 80 includes a connection jig 82, a gas intake pipe 74, a second exhaust gas treatment equipment 76, and a second vacuum pump 78. The connection jig 82 is attached to the service port 46 of the lower plate 26. The connection jig 82 is screwed to the lower plate 26, for example. The gas intake pipe 74 is connected to the connection jig 82.

The second exhaust gas treatment equipment 76 for removing toxic substances in the gas taken in through the gas intake pipe 74 is connected to the gas intake pipe 74. In addition, the second vacuum pump 78 for reducing the pressure in the gas intake pipe 74 is provided in the gas intake pipe 74.

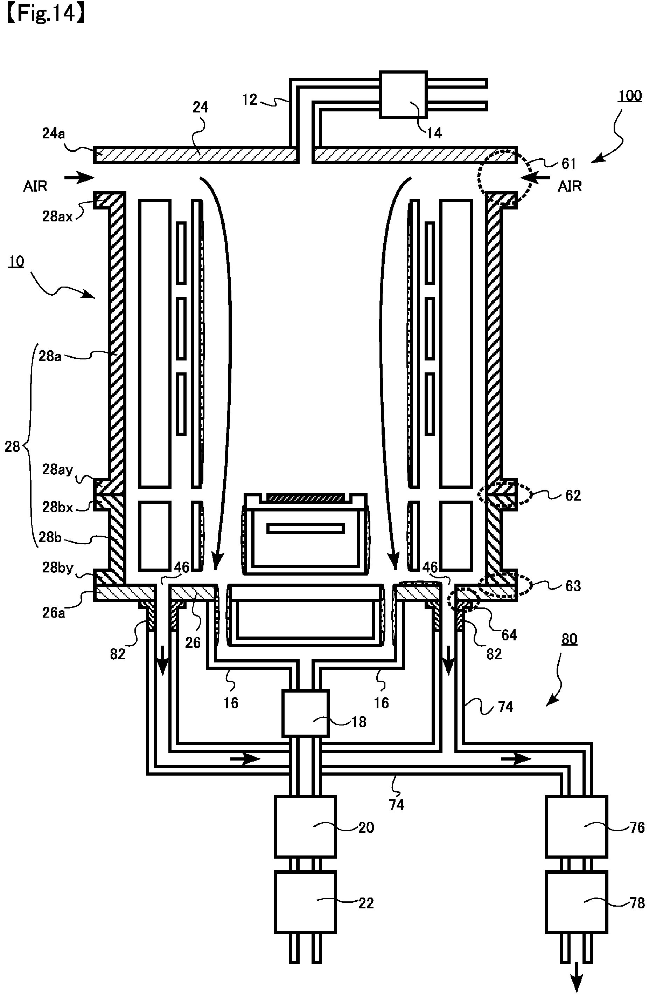

Then, the second vacuum pump 78 is operated to bring the gas intake pipe 74 to a pressure lower than atmospheric pressure. Air flows into the chamber 10 from the separated upper seal portion 61. The air that has flowed into the chamber 10 is sucked through the connection jig 82. The air sucked through the connection jig 82 flows into the gas intake pipe 74 (Fig. 14).

The by-products 66 adhering to the surface of the rotating body 32, the surface of the hood 38, the surface of the liner 40, the surface of the lower plate 26, and the surface of the gas exhaust port 44 react with the air to become secondary by-products. The secondary by-products are, for example, by-product gases. The generated by-product gases flow into the gas intake pipe 74 together with the air.

After the gas in the chamber 10 has been sucked for a predetermined time, the intake device 80 is removed from the service port 46. Then, the chamber 10 is completely opened to perform maintenance work inside the chamber 10.

As described above, according to the maintenance method for a semiconductor manufacturing apparatus according to the second embodiment, as in the first embodiment, it is possible to suppress the emission of gas derived from by-products remaining in the chamber to the outside of the apparatus.

### (Third Embodiment)

A maintenance method for a semiconductor manufacturing apparatus according to a third embodiment is different from the maintenance method for a semiconductor manufacturing apparatus according to the second embodiment in that the first seal portion seals between the upper wall and the lower wall. Hereinafter, the description of a part of the content overlapping the first or second embodiment may be omitted.

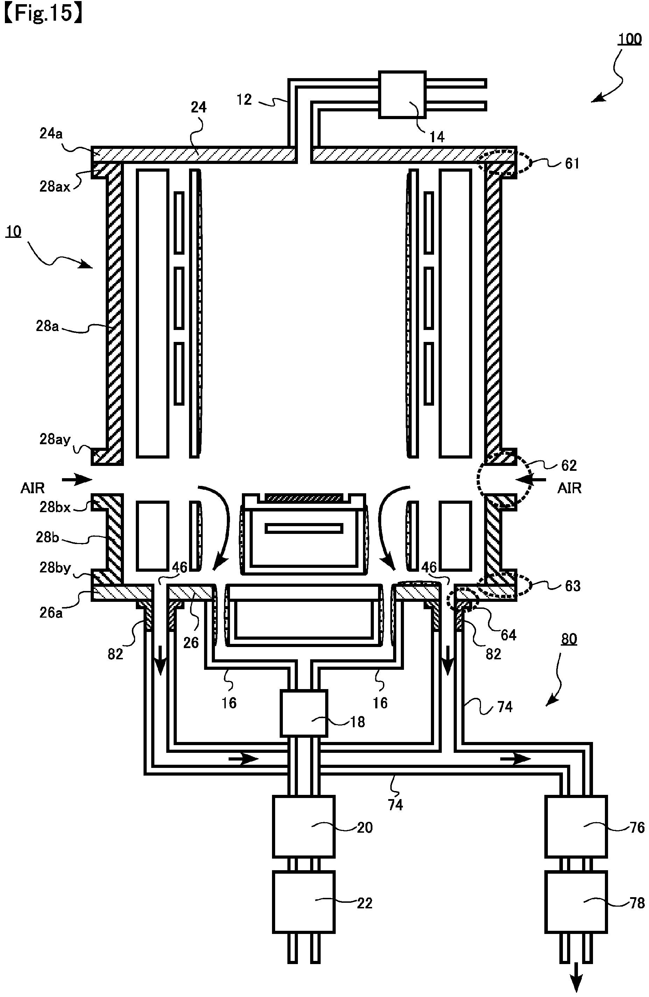

Fig. 15 is an explanatory diagram of the maintenance method for a semiconductor manufacturing apparatus according to the third embodiment.

For example, after a single crystal silicon carbide film is formed and the wafer W is unloaded from the chamber 10, the intermediate seal portion 62 and the service port seal portion 64 are separated. The intermediate seal portion 62 is an example of the first seal portion. The service port seal portion 64 is an example of the second seal portion.

For example, the upper wall 28a is moved upward with respect to the lower wall 28b by a lifting mechanism (not shown). As a result, the intermediate seal portion 62 is separated in the vertical direction.

In addition, for example, by removing the screws that attach the blank flange 48 to the lower plate 26, the service port seal portion 64 is separated in the vertical direction.

Then, the intake device 80 is attached to the separated service port seal portion 64.

Then, the second vacuum pump 78 is operated to bring the gas intake pipe 74 to a pressure lower than atmospheric pressure. Air flows into the chamber 10 from the separated intermediate seal portion 62. The air that has flowed into the chamber 10 is sucked through the connection jig 82. The air sucked through the connection jig 82 flows into the gas intake pipe 74.

The by-products 66 adhering to the surface of the rotating body 32, the surface of the hood 38, the surface of the liner 40, the surface of the lower plate 26, and the surface of the gas exhaust port 44 react with the air to become secondary by-products. The secondary by-products are, for example, by-product gases. The generated by-product gases flow into the gas intake pipe 74 together with the air.

After the gas in the chamber 10 has been sucked for a predetermined time, the intake device 80 is removed from the service port 46. Then, the chamber 10 is completely opened to perform maintenance work inside the chamber 10.

As described above, according to the maintenance method for a semiconductor manufacturing apparatus according to the third embodiment, as in the first and second embodiments, it is possible to suppress the emission of gas derived from by-products remaining in the chamber to the outside of the apparatus.

### (Fourth Embodiment)

A maintenance method for a semiconductor manufacturing apparatus according to a fourth embodiment is different from the maintenance method for a semiconductor manufacturing apparatus according to the second embodiment in that the first seal portion seals between the lower plate and the blank flange. Hereinafter, the description of a part of the content overlapping the first to third embodiments may be omitted.

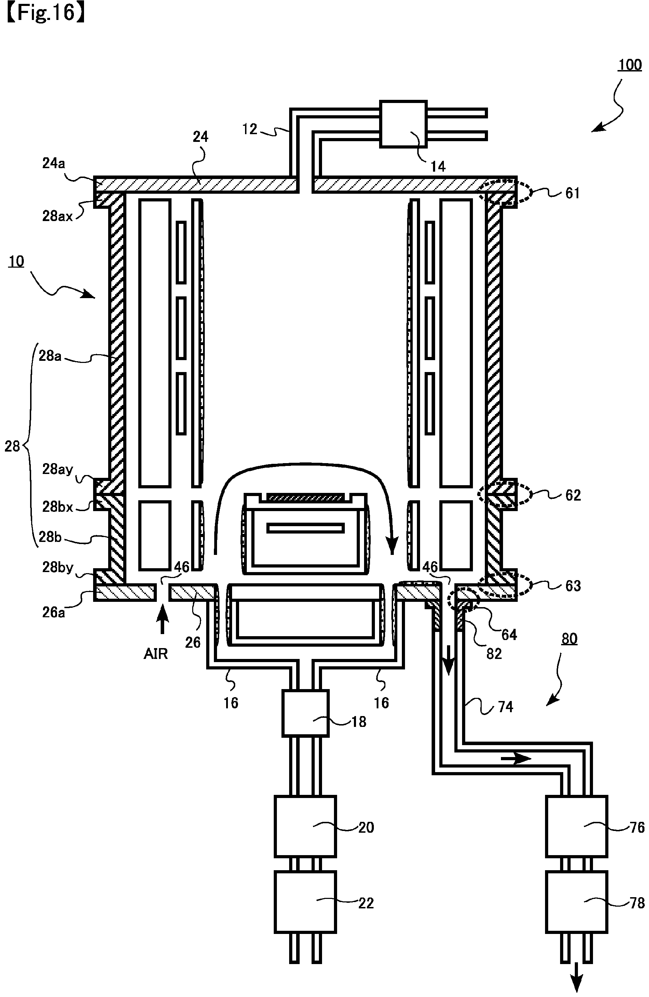

Fig. 16 is an explanatory diagram of the maintenance method for a semiconductor manufacturing apparatus according to the fourth embodiment.

For example, after a single crystal silicon carbide film is formed and the wafer W is unloaded from the chamber 10, the service port seal portion 64 is separated. The service port seal portion 64 is an example of the first seal portion. In addition, the another service port seal portion 64 is an example of the second seal portion.

For example, by removing the screws that attach the blank flange 48 to the lower plate 26, the service port seal portion 64 is separated in the vertical direction.

Then, the intake device 80 is attached to at least one of the separated service port seal portions 64.

The connection jig 82 of the intake device 80 is attached to at least one of the service ports 46 of the lower plate 26. The gas intake pipe 74 is connected to the connection jig 82.

Then, the second vacuum pump 78 is operated to bring the gas intake pipe 74 to a pressure lower than atmospheric pressure. Air flows into the chamber 10 from the service port 46 to which the intake device 80 is not attached. The air that has flowed into the chamber 10 is sucked through the connection jig 82. The air sucked through the connection jig 82 flows into the gas intake pipe 74.

The by-products 66 adhering to the surface of the rotating body 32, the surface of the hood 38, the surface of the liner 40, the surface of the lower plate 26, and the surface of the gas exhaust port 44 react with the air to become secondary by-products. The secondary by-products are, for example, by-product gases. The generated by-product gases flow into the gas intake pipe 74 together with the air.

After the gas in the chamber 10 has been sucked for a predetermined time, the intake device 80 is removed from the service port 46. Then, the chamber 10 is completely opened to perform maintenance work inside the chamber 10.

As described above, according to the maintenance method for a semiconductor manufacturing apparatus according to the fourth embodiment, as in the first to third embodiments, it is possible to suppress the emission of gas derived from by-products remaining in the chamber to the outside of the apparatus.

Up to now, the embodiments of the invention have been described with reference to specific examples. The embodiments are merely given as examples, and do not limit the invention. In addition, the components of the embodiments may be combined as appropriate.

In the embodiments, the case of forming a single crystal silicon carbide film has been described as an example. However, the invention can also be applied to the formation of a polycrystalline or amorphous silicon carbide film.

In addition, in the embodiments, the wafer formed of single crystal silicon carbide has been described as an example of the substrate. However, the substrate is not limited to the wafer formed of single crystal silicon carbide.

In addition, in the embodiments, the vapor phase growth apparatus has been described as an example of the semiconductor manufacturing apparatus. However, the semiconductor manufacturing apparatus is not limited to the vapor phase growth apparatus. For example, the invention can be applied to all semiconductor manufacturing apparatuses which include a chamber and in which by-products remain inside the chamber after a substrate is processed.

In the embodiments, the description of parts that are not directly required for the description of the invention, such as the apparatus configuration, the manufacturing method, and the maintenance method, is omitted. However, the required apparatus configuration, manufacturing method, maintenance method, and the like can be appropriately selected and used. In addition, all maintenance methods for semiconductor manufacturing apparatuses that include the elements of the invention and that can be appropriately modified by those skilled in the art are included within the scope of the invention. The scope of the invention is defined by the scope of claims and the scope of their equivalents.

### EXPLANATIONS OF LETTERS OR NUMERALS

- 10: CHAMBER

- 24: UPPER PLATE
- 26: LOWER PLATE
- 28: SIDEWALL
- 28a: UPPER WALL
- 28b: LOWER WALL
- 46: SERVICE PORT
- 48: BLANK FLANGE
- 61: UPPER SEAL PORTION (FIRST SEAL PORTION)
- 62: INTERMEDIATE SEAL PORTION (SECOND SEAL PORTION, FIRST SEAL PORTION)
- 63: LOWER SEAL PORTION (SECOND SEAL PORTION)
- 64: SERVICE PORT SEAL PORTION (SECOND SEAL PORTION, FIRST SEAL PORTION)
- 70: INTAKE DEVICE
- 72: ANNULAR JIG
- 72e: INTAKE PORT
- 80: INTAKE DEVICE
- 100: VAPOR PHASE GROWTH APPARATUS (SEMICONDUCTOR MANUFACTURING APPARATUS)
- W: WAFER (SUBSTRATE)

## Claims

1. A maintenance method for a semiconductor manufacturing apparatus, comprising:
separating a first seal portion and a second seal portion of a chamber having the first seal portion and the second seal portion;
introducing air into the chamber from the first seal portion being separated; and
sucking a gas in the chamber using an intake device from the second seal portion being separated.

2. The maintenance method according to claim 1,
**characterized in that** the chamber includes an upper plate, a lower plate, and a sidewall provided between the upper plate and the lower plate, and
the first seal portion seals between the upper plate and the sidewall.

3. The maintenance method according to claim 2,
**characterized in that** the sidewall includes an upper wall and a lower wall provided between the upper wall and the lower plate, and
the second seal portion seals between the upper wall and the lower wall or between the lower wall and the lower plate.

4. The maintenance method according to claim 3,
**characterized in that** the intake device includes an annular jig having an intake port on its inner surface, and
the annular jig is interposed between the upper wall and the lower wall or between the lower wall and the lower plate so that the gas is sucked through the intake port.

5. The maintenance method according to claim 2,
**characterized in that** the chamber includes a blank flange for closing a service port provided in the lower plate, and
the second seal portion seals between the lower plate and the blank flange.

6. The maintenance method according to claim 1,
**characterized in that**, after processing a substrate in an atmosphere containing chlorine in the chamber, the first seal portion and the second seal portion are separated.
